# EUROPÄISCHE PATENTSCHRIFT

(11) **EP 2 837 458 B1**
(45) Veröffentlichungstag und Bekanntmachung des Hinweises auf die Patenterteilung: **12.10.2016**
(21) Anmeldenummer: 13180321.5
(22) Anmeldetag: 14.08.2013
(51) Int. Cl.: B23K 1/00, B23K 1/005, B23K 20/00, H01L 23/00, H05K 3/10, H05K 3/22

(54) **Laserstrahllötsystem mit einem Lotdrahtvorschubsystem und mit einem Lackdrahtvorschubsystem**
System for Laser beam soldering having a soldering wire feeder system and a coated wire feeder system
Système de brasage par rayon laser avec un système d'amenée de fil de brasure et un systéme d'amenée de fil revétu

(43) Veröffentlichungstag der Anmeldung: 18.02.2015
(73) Patentinhaber: SICK AG, 79183 Waldkirch (DE)
(72) Erfinder: Leitschuh, Daniel, 79106 Freubzrg (DE); Spreemann, Dirk, Dr., 79244 Münstertal (DE); Landwehr, Maximilian, 79215 Elzach (DE)
(74) Vertreter: Ludewigt, Christoph

(56) Entgegenhaltungen:
- JP-A- S59 232 666
- US-A- 3 289 452
- US-A- 3 742 182
- US-A- 4 031 612
- US-B1- 6 352 197

## Beschreibung

Die Erfindung betrifft ein Laserstrahllötsystem mit den Merkmalen des Oberbegriffs des Anspruchs 1 (siehe, z.B. US 4 031 612 A).

Elektronische Schaltungen und Geräte weisen in der Regel eine Vielzahl von Unterbaugruppen und/oder einzelnen elektronischen Bauteilen auf, die im Rahmen des Herstellungsprozesses miteinander elektrisch verbunden werden müssen. Dabei gibt es eine Reihe von Erwägungen und Randbedingungen, die die Wahl der Vorgehensweise bei der technischen Realisierung der elektrischen Verbindungen im Herstellungsprozess beeinflussen. Neben Prozesssicherheit, Geschwindigkeit und Herstellkosten spielt dabei auch die Flexibilität der Verbindung eine Rolle, wobei in die Flexibilität auch die Zahl der realisierbaren Verbindungen und Freiheitsgrade hinsichtlich der Positionierbarkeit und des "Routings" (d. h. der Verbindungsführung), wie sie durch realisierbare Verbindungslängen und mechanische Verformbarkeit der Verbindung beeinflusst werden, als Parameter einfließen.

Eine bereits aus dem Stand der Technik bekannte Möglichkeit zur Herstellung der elektrischen Verbindung ist die Verwendung von Lackdrähten, deren Enden jeweils durch eine Lötverbindung mit Kontakten der miteinander zu verbindenden Baugruppen oder Bauteile verbunden sind. Diese Vorgehensweise, die beispielsweise im Zusammenhang mit der Kontaktierung von Mikrosystemen aus der DE 10 2007 007 618 B3 bekannt ist, zeichnet sich insbesondere durch eine sehr hohe erreichbare Flexibilität im vorstehend genannten Sinne aus.

Als besonders gut geeignete Möglichkeit zum Verlöten von Lackdrähten hat sich das Laserstrahllöten bewährt, die ebenfalls in der DE 10 2007 007 618 B3 diskutiert wird. Dieses ursprünglich vom Fraunhofer-Institut für Lasertechnik ILT entwickelte Verfahren, bei dem die Wärmezufuhr zur Verflüssigung des Lots durch einen Laser erreicht wird, zeichnet sich insbesondere dadurch aus, dass es keinen separaten Prozessschritt zum Entlacken des Verbindungsdrahts benötigt, da bedingt durch die Wärmeeinwirkung des flüssigen Lots auf den Draht die isolierende Lackschicht abgeschmolzen wird, so dass die lokale Entlackung des Drahtes parallel zur Kontaktierung erfolgen kann. Dabei können die Steuerung und Positionierung des Lasers relativ zu den jeweils herzustellenden Lötstellen durch einen Computer automatisiert erfolgen.

Aus dem Stand der Technik ist es ebenfalls bekannt, den Lotdraht automatisiert bereitzustellen. Zu diesem Zweck dienende Lotdrahtvorschubsysteme sind beispielsweise aus der DE 10 2004 054 925 A1 bekannt.

Nach den genannten Prinzipien arbeitende Laserstrahllötsysteme mit denen es möglich ist, eine flexible Kontaktierung elektrischer Bauelemente über Lackdrähte zu realisieren, sind beispielsweise von der Firma Wolf Produktionssysteme in Freudenstadt erhältlich.

Allerdings ist es bei bekannten Laserstrahllötsystemen zur flexiblen Kontaktierung von elektrischen Bauelementen mittels Lackdraht notwendig, den Lackdraht über ein separates Handlingsystem oder von Hand zu positionieren. Eine optimierte, insbesondere eine vollautomatische Durchführung des Laserstrahllötens ist damit nicht möglich.

Die US 4 031 612 A offenbart ein Laserstrahllötsystem, wobei die Werkstückaufnahme relativ zum Lasersystem bewegt wird.

Die US 3 742 182 A offenbart ein Verfahren zur Konstruktion einer Vielzahl von Löchern in einem Blechmaterial durch Abtasten mittels eines kohärenten Laserstrahls der Löcher in einer Maske.

Die US 6 352 197 B1 offenbart eine Vorrichtung zum Drahtbonden zwischen einem ersten und einem zweiten Verbindungsteil eines elektronischen Bauteils.

Die US 3 289 452 A offenbart ein Verfahren zum Kontaktieren von Halbleiterbauelementen durch Thermokompression.

Die JP S59 232666 A offenbart ein Verfahren, um ein Verbindungsstück aufzulöten.

Die Aufgabe der Erfindung besteht daher darin, ein verbessertes Laserstrahllötsystem bereitzustellen, mit dem das Laserstrahllöten mit einem höheren Automatisierungsgrad durchführbar ist. Diese Aufgabe wird gelöst durch ein Laserstrahllötsystem mit den Merkmalen des Anspruchs 1. Bevorzugte Weiterbildungen der Erfindung sind Gegenstand des Unteranspruche.

Das erfindungsgemäße Laserstrahllötsystem weist eine Werkstückaufnahme, eine Laserstrahlquelle und ein Lotdrahtvorschubsystem auf. Dabei sind die Laserstrahlquelle und das Lotdrahtvorschubsystem einerseits relativ zu der Werkstückaufnahme sowohl in einer Ebene parallel zu der Werkstückaufnahme als auch senkrecht zur Werkstückaufnahme verschiebbar angeordnet und andererseits um eine senkrecht zur Werkstückaufnahme stehende Achse rotierbar angeordnet. Um eine einfachere Nomenklatur zu erlauben, wird im Folgenden die Richtung senkrecht zur Werkstückaufnahme als z-Richtung bezeichnet. Zu dieser z-Richtung lässt sich dann ein dreiachsiges kartesisches Koordinatensystem mit senkrecht auf der z-Achse und aufeinander stehenden x- und y-Achsen definieren, so dass die x-und y-Richtung in einer Ebene parallel zur Werkstückaufnahme liegen.

Durch diese Bewegungsfreiheitsgrade, die insbesondere angetriebene, von einer Steuerungseinrichtung angesteuerte Bewegungen ermöglichen, ist sichergestellt, dass an allen gewünschten Kontaktpunkten von in der Werkstückaufnahme in einer gewünschten Position zueinander angeordneten Elektronikbausteinen oder Elektronikbaugruppen, die mittels Lackdraht miteinander verbunden werden sollen, ein Laserlötprozess durchgeführt werden kann.

Erfindungswesentlich ist, dass das Laserstrahllötsystem ferner ein Lackdrahtvorschubsystem, ein System zum Führen und Positionieren des Lackdrahts und eine Vorrichtung zum Durchtrennen des Lackdrahts, die in diesem Text als "Schneidvorrichtung" bezeichnet wird, was aber keine Beschränkung auf Vorrichtungen, die eine Trennung durch einen Schneidprozess im engeren Sinne bedeuten soll, sondern äquivalent zu der Bezeichnung "Trennvorrichtung" zu verstehen ist, aufweist. Das Lackdrahtvorschubsystem, das System zum Führen und Positionieren des Lackdrahts und die Schneidvorrichtung sind ebenfalls relativ zu der Werkstückaufnahme in einer Ebene parallel zu der Werkstückaufnahme und senkrecht zur Werkstückaufnahme verschiebbar angeordnet und um eine senkrecht zur Werkstückaufnahme stehende Achse rotierbar angeordnet.

Grundsätzlich können diese Bewegungen unabhängig von den Bewegungen der Laserstrahlquelle und des Lotdrahtvorschubsystems durchgeführt werden, es reicht aber in der Regel bereits aus, wenn sie gemeinsam mit den Bewegungen von Laserstrahlquelle und Lotdrahtvorschubsystem ausgeführt werden, so dass die Komponenten auch an einer einzigen, gemäß den genannten Freiheitsgraden relativ zur Werkstückaufnahme bewegbaren Halterung angeordnet werden können. Je nach gewählter Ausführung können auch die zusätzlichen Komponenten angetrieben sein und von einer Steuerungseinrichtung gesteuert werden.

Der Erfindung liegt die Erkenntnis zu Grunde, dass es beim Lackdrahtlöten möglich ist, die ohnehin zum Verlöten der unterschiedlichen Lötstellen zwingend erforderliche Repositionierung von Laserstrahlquelle und Lotdrahtvorschubsystem relativ zum Werkstück bzw. der Werkstückaufnahme, auf der das Werkstück bei seiner Bearbeitung gelagert ist, d. h. die erforderliche Relativbewegung zwischen dem Werkstückaufnahme einerseits und Laserstrahlquelle und Lotdrahtvorschubsystem andererseits, gleichzeitig zum Verlegen des Lackdrahts zwischen einem gegebenen, soeben verlöteten Kontaktpunkt und einem mit diesem zu verbindenden Kontaktpunkt zu nutzen. Dies bedingt allerdings nicht nur, dass lokal eine Möglichkeit zum Schneiden des Lackdrahts in Gestalt einer Schneidvorrichtung bereitgestellt werden muss. Es hat sich ferner erwiesen, dass der Lackdraht durch eine Lackdrahtvorschubeinrichtung aktiv zugeführt werden muss, also nicht einfach von einer Haspel durch die Bewegung abgezogen werden darf, und dass insbesondere bei Bedarf für komplexe, einander überkreuzende Lackdrahtverbindungen ein System zum Führen und Positionieren des Lackdrahts notwendig ist. Allerdings können, wie weiter unten detaillierter beschrieben wird, Lackdrahtvorschubsystem, System zum Führen und Positionieren des Lackdrahts und Schneidvorrichtung zumindest teilweise ineinander integriert werden.

Der Vollständigkeit halber sei ergänzend angemerkt, dass die Laserstrahlquelle optional auch eine Bearbeitungsoptik aufweisen kann, um mit dieser Eigenschaften des Laserstrahls für den gewünschten Lötprozess optimieren kann. Zweckmäßig für einen kontrollierten Lötprozess ist auch das Vorsehen von Lotüberwachungssystemen. Eine zusätzliche Kontrolle der Positionierung der Optik und des Lotdrahts ist bevorzugt durch Kamerasysteme, insbesondere durch zwei Kamerasysteme, von denen eines koaxial und das andere in off-axis-Position angeordnet ist, erreichbar.

Gemäß der Erfindung ist die Schneidvorrichtung zum Durchtrennen des Lackdrahts in das System zum Führen und Positionieren des Lackdrahts integriert. Dies bietet sich insbesondere dann an, wenn das Routing der herzustellenden Lackdrahtverbindungen hohe Anforderungen an das benötigte System zum Führen und Positionieren des Lackdrahts stellt.

In der Ausführungsform eines so ausgestalteten Laserstrahllötsystems in diesen Erfindung ist vorgesehen, dass das System zum Führen und Positionieren des Lackdrahts mindestens eine erste Platte und eine zweite Platte, die mittels mindestens eines Antriebs unabhängig voneinander verschiebbar sind und jeweils mindestens eine Bohrung aufweisen, die so angeordnet ist, dass in mindestens einer relativen Position der ersten Platte und der zweiten Platte zueinander die Bohrung der ersten Platte und die Bohrung der zweiten Platte zumindest partiell überlappen und dass in mindestens einer relativen Position der ersten Platte und der zweiten Platte zueinander die Bohrung der ersten Platte und die Bohrung der zweiten Platte nicht überlappen.

Im Betrieb des Laserstrahllötsystems wird der Lackdraht dann durch die Bohrungen der ersten Platte und der zweiten Platte vorgeschoben, wenn sie ganz oder teilweise überlappen. Durch gemeinsames Verfahren beider Platten oder Verfahren beider Platten relativ zueinander, was insbesondere auch während der Bewegung von einem ersten Lötpunkt zu einem zweiten Lötpunkt erfolgen kann, kann dann die Führung und Formgebung des Lackdrahtes gezielt beeinflusst werden. Der Schneidvorgang wird durchgeführt, indem die erste Platte und die zweite Platte in eine Position verfahren werden, in der die Bohrung der ersten Platte und die Bohrung der zweiten Platte nicht mehr überlappen. Dabei wird dann der Lackdraht abgeschert oder, insbesondere wenn die Bohrungen vorteilhafterweise Schneidkannten aufweisen, abgeschnitten.

Insbesondere für die Schaffung von Lackdrahtverbindungen bei Anwendungen, die weniger komplexe Verbindungsführungen aufweisen, aber auch zusätzlich zu der vorstehend beschriebenen Ausgestaltung kann das System zum Führen und Positionieren des Lackdrahts eines entsprechenden Laserstrahllötsystems einen Niederhalter aufweisen.

Die Erfindung wird nachfolgend anhand von Figuren näher erläutert. Es zeigt:
- Fig. 1a:: ein erstes Beispiel einer Verbindung von zwei Elektronikbauteilen mittels Lackdraht,
- Fig. 1b:: ein zweites Beispiel einer Verbindung von zwei Elektronikbauteilen mittels Lackdraht,
- Fig. 2:: ein Ausführungsbeispiel für ein Laserstrahllötsystem,
- Fig. 3a:: das System zum Führen und Positionieren des Lackdrahts mit darin integrierter Schneidvorrichtung für den Lackdraht gemäß dem Ausführungsbeispiel aus Figur 2 in einer ersten Betriebsposition,
- Fig. 3b:: das System zum Führen und Positionieren des Lackdrahts mit darin integrierter Schneidvorrichtung für den Lackdraht gemäß dem Ausführungsbeispiel aus Figur 2 in einer zweiten Betriebsposition,
- Fig. 3c:: das System zum Führen und Positionieren des Lackdrahts mit darin integrierter Schneidvorrichtung für den Lackdraht gemäß dem Ausführungsbeispiel aus Figur 2 in einer dritten Betriebsposition,
- Fig.: 4:ein Beispiel für ein Laserstrahllötsystem,
- Fig. 5:: den Grundaufbau eines Lackdrahtvorschubsystems, wie es in den Beispielen gemäß den Figuren 2, 4 und 9 verwendet wird,
- Fig. 6:: eine Weiterbildung des Grundaufbaus des Lackdrahtvorschubsystems aus Figur 5, wie sie im Beispiel gemäß Figur 4 verwendet wird
- Fig. 7:: ein Beispiel für ein Laserstrahllötsystem,
- Fig. 8:: eine Detailansicht des Beispiels des Laserstrahllötsystems gemäß Figur 7, welche das Lackdrahtvorschubsystem, das System zum Führen und Positionieren des Lackdrahts, die Schneidvorrichtung und das Lotdrahtzuführ-system zeigt,
- Fig. 9:: ein Beispiel für ein Laserstrahllötsystem, bei welchem die Schneidvorrichtung als thermische Schneidvorrichtung ausgeführt ist,
- Fig. 10:: eine erste Variante einer thermischen Schneidvorrichtung für das Beispiel gemäß Figur 9, und
- Fig. 11:: eine zweite Variante einer thermischen Schneidvorrichtung für das Beispiel gemäß Figur 9.

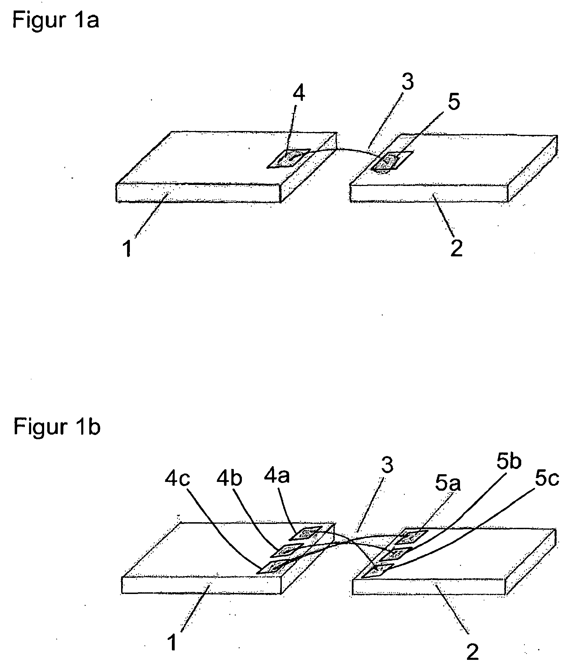

Die Figuren 1a und 1b zeigen zwei Beispiele für die als solche aus dem Stand der Technik bereits bekannte gelötete elektrische Verbindung von elektrischen Baugruppen 1, 2 mittels Lackdrähten 3. Die elektrischen Baugruppen 1, 2 sind dabei als Leiterplatten realisiert, die in Figur 1a jeweils ein Kontaktfeld 4, 5 bzw. in Figur 1b jeweils mehrere Kontaktfelder 4a, 4b, 4c, 5a, 5b, 5c aufweisen.

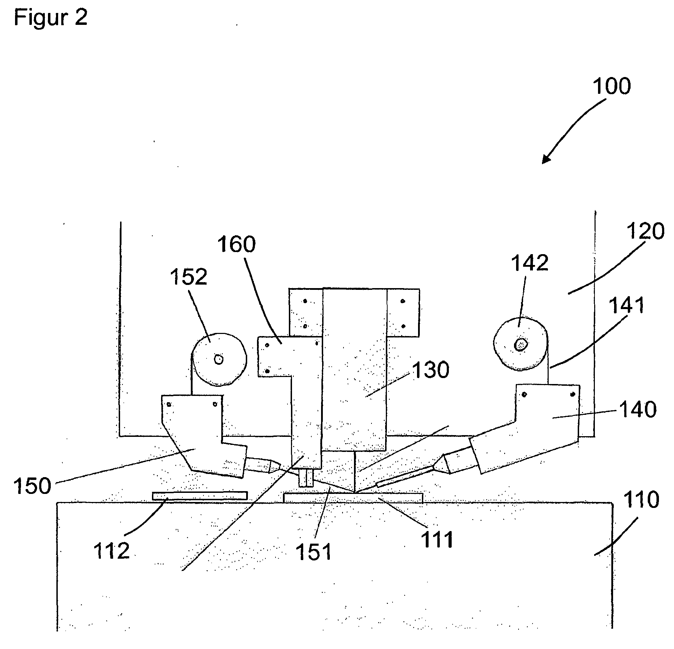

Figur 2 zeigt ein erstes Ausführungsbeispiel für ein Laserstrahllötsystem 100. Das Laserstrahllötsystem 100 weist eine Werkstückaufnahme 110 und einen Werkzeugträger 120 auf. Dabei ist das Laserstrahllötsystem 100 so gestaltet, dass eine translatorische Relativbewegung zwischen Werkstückaufnahme 110 und Werkzeugträger 120 in alle drei Raumrichtungen (also insbesondere in einer parallel zur Werkstückaufnahme verlaufenden Ebene und senkrecht dazu) und eine rotatorische Relativbewegung um eine senkrecht zur Werkstückaufnahme verlaufende Achse durchgeführt werden kann, die bevorzugt durch von einer nicht dargestellten Steuereinheit über nicht dargestellte Antriebseinheiten realisiert wird.

In die Werkstückaufnahme 110 ist in der Darstellung der Figur 2 das Werkstück aufgenommen, das hier exemplarisch durch zwei elektrische Baugruppen 111, 112 repräsentiert wird, die durch Verlöten von Lackdrähten miteinander in elektrische Verbindung gebracht werden sollen.

Am Werkzeugträger 120 ist eine Laserquelle 130 so angeordnet, dass ein durch die Laserquelle 130 bereitgestellter Laserstrahl 131, in Richtung auf die Werkstückaufnahme 110 ausgesandt wird, so dass er auf eine Stelle der in der Werkstückaufnahme 110 aufgenommenen elektrischen Baugruppen 111, 112 trifft. Die Laserquelle 130 kann auch nicht dargestellte optische Elemente enthalten, mit denen Eigenschaften des Laserstrahls 131 beeinflussbar sind.

Ferner ist am Werkzeugträger 120 ein Lotdrahtvorschubsystem 140 angeordnet, das so ausgerichtet ist, dass Lotdraht 141, der in diesem Beispiel von einer Lotdrahthaspel 142 abgerollt wird, durch das Lotdrahtvorschubsystem 140 so vorwärtsgeschoben wird, dass der Lotdraht 141 an einer definierten Position in den Laserstrahl 131 eintritt, und von diesem erwärmt wird, bis der Lotdraht 141 schmilzt. Mögliche Arten des Aufbaus des Lotdrahtvorschubsystems 140 sind aus dem Stand der Technik bekannt.

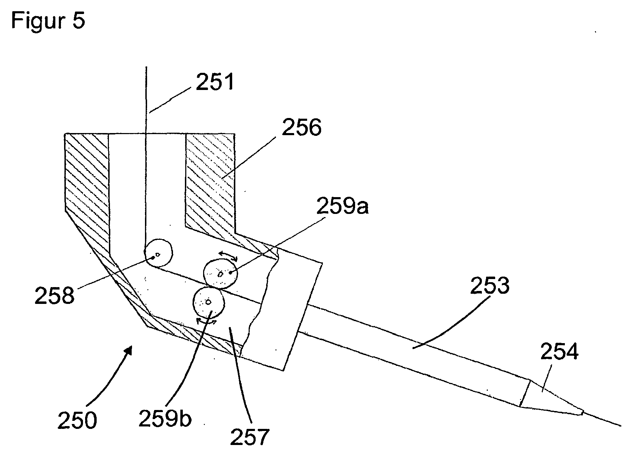

Noch weiter ist am Werkzeugträger 120 ein Lackdrahtvorschubsystem 150 angeordnet, von dem Lackdraht 151 von einer Lackdrahthaspel 152 abgerollt und von in Figur 2 nicht dargestellten Antrieb, der z. B. wie in Figur 5 gezeigt angeordnet sein kann, in Richtung auf den Laserstrahl 131 vorwärtsgeschoben wird.

In dem dem Laserstrahl 131 zugewandten Endabschnitt des Lackdrahtvorschubsystems 150 ist der Lackdraht in einem Führungsrohr 153 geführt, welches eine konusförmige Spitze 154 mit einer Austrittsöffnung 155 aufweist. Der exakte Verlauf des Lackdrahts 151 im Raum wird durch ein System zum Führen und Positionieren 160 des Lackdrahts 151 mit integrierter Schneidvorrichtung 170, das am Werkzeugträger 120 so angeordnet ist, dass es den Verlauf des Lackdrahts 151 beeinflussen kann, bestimmt.

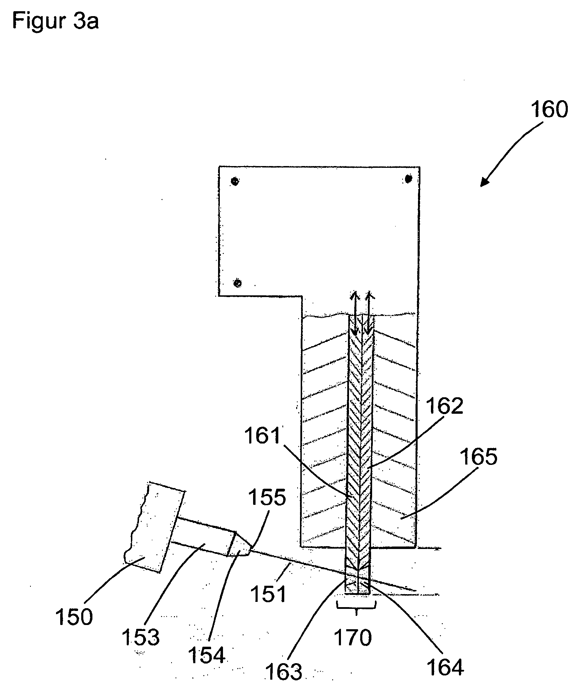

Der Aufbau des Systems zum Führen und Positionieren 160 des Lackdrahts 151 mit integrierter Schneidvorrichtung in der Ausführungsform des Laserstrahllötsystems 100 gemäß Figur 2 ist detaillierter z. B. in den Figuren 3a bis 3c dargestellt, die das System zum Führen und Positionieren 160 in unterschiedlichen Betriebspositionen zeigen. Das System zum Führen und Positionieren 160 umfasst insbesondere eine erste und eine zweite in z-Richtung unabhängig voneinander, insbesondere durch einen Antrieb, verschiebbare, in den Richtungen senkrecht dazu in einer Führung 165 geführte Platten 161, 162 als Schneidplatten, die in ihren vom Werkzeugträger 120 fortweisenden Endbereichen jeweils eine Bohrung 163, 164 aufweisen. Der Rand der Bohrungen 163, 164 kann dabei schräg verlaufen und insbesondere als Schneidkante ausgestaltet sein.

Die erste Platte 161 und die zweite Platte 162 sind so relativ zueinander bewegbar angeordnet, dass in mindestens einer relativen Position der ersten Platte 161 und der zweiten Platte 162 zueinander die Bohrung 163 der ersten Platte 161 und die Bohrung 164 der zweiten Platte 162 zumindest partiell überlappen und dass in mindestens einer relativen Position der ersten Platte 161 und der zweiten Platte 162 zueinander die Bohrung 163 der ersten Platte 161 und die Bohrung 164 der zweiten Platte 162 nicht überlappen.

Insbesondere kann die Position der ersten Platte 161 und der zweiten Platte 162 während des Vorschubs des Lackdrahts 151 während der Bewegung zwischen zwei zu erzeugenden Lotstellen so gewählt sein, dass, wie in Figur 3a dargestellt, der Lackdraht 151 frei durch die Bohrungen 163,164 geschoben wird, ohne deren Rand zu berühren. Bei diesem freien Vorschub verläuft der Lackdraht dann im in Figur 3a nicht dargestellten Laserstrahl 131 zugewandten Endbereich des Systems zum Führen und Positionieren 160 des Lackdrahts 151 in einem Abstand I (in z-Richtung gemessen) von der Führung 165.

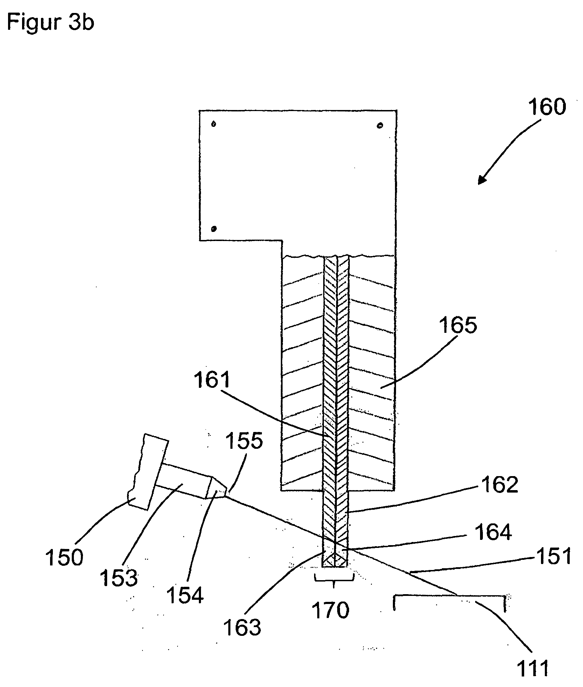

Durch die Verschiebbarkeit der ersten Platte 161 und der zweiten Platte 162 relativ zueinander besteht aber auch die Möglichkeit, den Verlauf des Drahtes auf eine gewünschte Weise zu beeinflussen. Exemplarisch ist dies in Figur 3b dargestellt, in der die erste Platte 161 und die zweite Platte 162 im Vergleich zu der Darstellung gemäß Figur 3a gemeinsam in Richtung auf die Werkstückaufnahme, also in z-Richtung, verschoben sind. Sobald der Lackdraht 151 bei dieser Verschiebung mit der Innenfläche der Bohrung 163 in Kontakt kommt, wird er gemeinsam mit der Platte 161 verschoben, was auch zu einer Bewegung des Lackdrahts 151 in der Austrittsöffnung 155 führt. Gelangt dann der Lackdraht 151 in Kontakt zum Rand der Austrittsöffnung 155, kommt es zu einem Biegen oder Knicken des Lackdrahts 151, das man sich beispielsweise zu Nutze machen kann, um den Lackdraht 151 in eine gewünschte Position zum Löten zu bringen. Die exakte Positionierung und/oder der Vorschub des Lackdrahts 151 kann, wie auch bei allen nachfolgend beschriebenen Ausführungsformen, vorteilhaft durch Sensorik überwacht und durch Steuerung beeinflusst werden. Als Sensorik bietet sich insbesondere die Verwendung von nicht dargestellten Kamerasystemen an.

Dies verdeutlicht exemplarisch, dass durch die Verschiebbarkeit der ersten Platte 161 und der zweiten Platte 162 relativ zueinander die Formgebung und der Verlauf des Lackdrahts 151 im Raum beeinflusst werden kann, was der Herstellung komplexer Lackdrahtverbindungen zwischen einzelnen Lötfeldern 4, 4a, 4b, 4c, 5, 5a, 5b, 5c zuträglich ist. Bereits an dieser Stelle sei darauf hingewiesen, dass dann, wenn das Ende des Lackdrahts 151 bereits verlötet ist, wegen der Führung des Lachdrahts 151 durch die Bohrungen 163,164 der ersten Platte 161 und der zweiten Platte 162 auch eine Verformung des Lackdrahts 151, die dessen Verlaufsrichtung in der Ebene der Werkstückaufnahme 110 ändert, herbeigeführt werden kann, wenn eine relative Rotation zwischen Werkstückaufnahme 110 und Werkzeugträger 120 herbeigeführt wird.

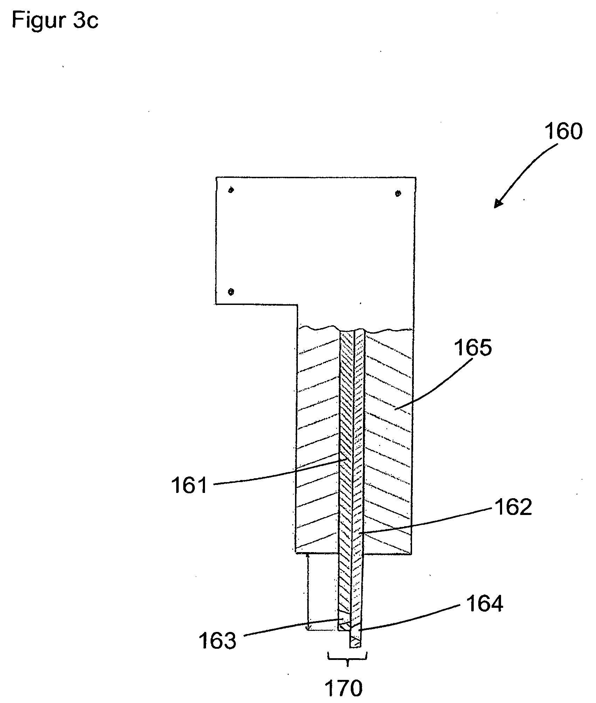

Schließlich wird durch die relative, bevorzugt angetriebene Verschiebbarkeit der ersten Platte 161 und der zweiten Platte 162 relativ zueinander ein Abtrennen des Lackdrahts 151 ermöglicht, wie in der Figur 3c zu erkennen ist. In der relativen Position der ersten Platte 161 und der zweiten Platte 162 zueinander, die in Figur 3c dargestellt ist, überlappen die Bohrungen 163, 164 nicht mehr miteinander. Dementsprechend wird der Lackdraht 151, während die Platten 161, 162 in diese Position zueinander verbracht werden, was durch gegenläufige Bewegung der ersten Platte 161 und der zweiten Platte 161 in z-Richtung erfolgt, abgeschert.

Im Betrieb des in Figur 2 dargestellten Laserlötsystems 100 wird zunächst durch eine translatorische Relativbewegung zwischen Werkstückaufnahme 110 und Werkzeugträger 120 sichergestellt, dass der Laserstrahl 131, wenn er erzeugt wird, im Bereich eines ersten Kontaktfelds 4 eines elektrischen Bauelements liegt, das mittels des Lackdrahts 151 mit einem zweiten Kontaktfeld 5 verbunden werden soll.

Durch diese Relativbewegung und/oder durch eine Beeinflussung des Verlaufs des Lackdrahts 151 mittels des Lackdrahtvorschubsystem 150 und/oder mittels des Systems zum Führen und Positionieren 160 des Lackdrahts 151 wird dann im Bereich des Kontaktfelds 4 Lackdraht 151 bereitgestellt, bei dem dann bevorzugt aufgrund der Wärmeeinwirkung des schmelzenden Lotes, hervorgerufen durch einen ersten Laserpuls die Lackummantelung entfernt wird. Mittels der Lotdrahtvorschubeinrichtung 140 wird Lotdraht 141 in diesem Bereich bereitgestellt, so dass der Laserstrahl 131, wenn er eingeschaltet wird, den Lotdraht 141 schmilzt und einen ersten Lötpunkt erzeugt. Der Vollständigkeit halber sei explizit darauf hingewiesen, dass dabei die Richtung, in der der Lackdraht 151 den ersten Lötpunkt verlässt, durch den Rotationsfreiheitsgrad bezüglich der senkrecht zur Werkstückaufnahme 110 verlaufenden Achse gewählt werden kann.

Durch translatorische Relativbewegung zwischen Werkstückaufnahme 110 und Werkzeugträger 120 wird dann eine Position angesteuert, in der der Laserstrahl 131, wenn er eingeschaltet ist, mit dem Kontaktfeld 5, zu dem die elektrische Verbindung über den Lackdraht 151 hergestellt werden soll, wechselwirkt. Während der Bewegung wird Lackdraht 151 von dem Lackdrahtvorschubsystem 150 nachgeführt. Durch den Weg im Raum, der bei der translatorischen Relativbewegung beschritten wird und etwaige zusätzliche Rotationen bezüglich der senkrecht zur Werkstückaufnahme 110 verlaufenden Achse kann der Verlauf des Lackdrahts dabei gezielt beeinflusst werden, was insbesondere dann, wenn ein komplexes System von Verbindungen hergestellt werden muss, einen wesentlichen Vorteil darstellt.

Wenn die Zielposition über dem Kontaktfeld 5 erreicht wurde und der Lackdraht 151 relativ zu diesem durch das System zum Führen und Positionieren 160 des Lackdrahts 151 auf die gewünschte Weise positioniert wurde, kann die isolierende Lackschicht durch Aktivierung des Laserstrahls 131 entfernt und, nachdem Lotdraht 141 durch das Lotdrahtvorschubsystem 140 bereitgestellt wurde, ein weiterer Lötpunkt durch Schmelzen des Lotdrahts 141 durch den Laserstrahl 131 erzeugt werden.

Erfordert die Anwendung, dass ein weiterer Kontakt mit den auf diese Weise über den Lackdraht 151 miteinander verbundenen Kontaktfeldern 4, 5 hergestellt werden muss, kann unmittelbar wieder wie vorstehend beschrieben die nächste zu realisierende Lötstelle angefahren werden. Ist dies nicht der Fall, wird der Lackdraht 151 mittels der in das System zum Führen und Positionieren 160 integrierten Schneidvorrichtung 170 durchtrennt und der erste Lötpunkt einer weiteren zu erstellenden Lackdrahtverbindung, die auf gleiche Weise wie eben beschrieben wurde erzeugt werden kann, durch Relativbewegung zwischen Werkzeugaufnahme 110 und Werkzeugträger 120 angesteuert.

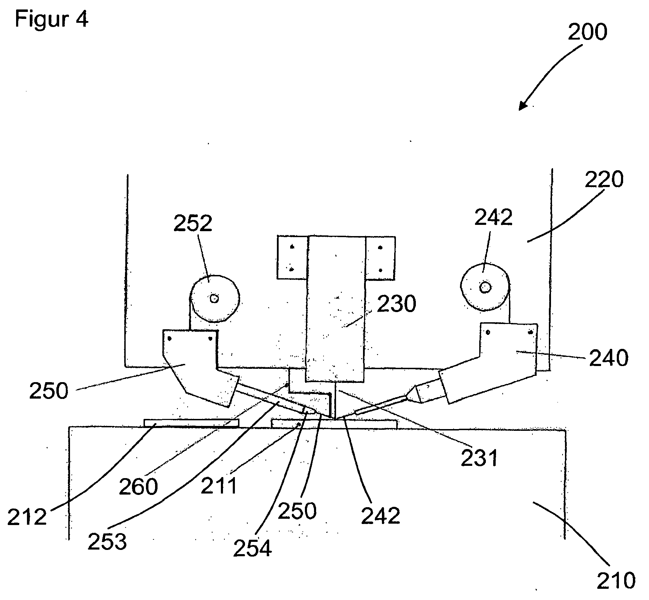

Bereits an dieser Stelle sei angemerkt, dass die grundsätzliche Vorgehensweise bei Verwendung der nachfolgend beschriebenen alternativen Laserlötsysteme 200, 300 bzw. 400 gemäß Figuren 4, 7 bzw. 9 im Wesentlichen gleich ist wie beim soeben beschriebenen Erzeugen von gelöteten Lackdrahtverbindungen mit dem Laserlötsystem 100.

Figur 4 zeigt ein Beispiel eines Laserlötsystems 200 mit Werkstückaufnahme 210 mit elektrischen Baugruppen 211, 212, Werkzeugträger 220, Laserquelle 230 mit Laserstrahl 231, Lotdrahtvorschubsystem 240 mit Lotdraht 241 und Lotdrahthaspel 242, Lackdrahtvorschubsystem 250 mit Lackdraht 251, Lackdrahthaspel 252, Führungsrohr 253 mit konusförmiger Spitze 254 und Austrittsöffnung 255 und System zum Führen und Positionieren 260 des Lackdrahts 251 sowie eine Schneidvorrichtung 270.

Das Laserlötsystem 200 unterscheidet sich dabei vom Laserlötsystem 100 gemäß Figur 2 einerseits dadurch, dass die Schneidvorrichtung in das Lackdrahtvorschubsystem 250 integriert ist und andererseits dadurch, dass das System zum Führen und Positionieren 260 des Lackdrahts 251 als Niederhalter ausgestaltet ist, der vorzugsweise zumindest in Richtung senkrecht zur Ebene der Werkstückaufnahme 210 - jedoch besonders bevorzugt auch in der Ebene der Werkstückaufnahme 210 - verschiebbar, insbesondere angetrieben verschiebbar ist.

Zur Beschreibung des Aufbaus sowohl des Lackdrahtvorschubsystems 150 als auch des Lackdrahtvorschubsystem 250 als auch des weiter unten beschriebenen Lackdrahtvorschubsystems 450 kann dabei zunächst Figur 5 beigezogen werden. Figur 5 zeigt das Lackdrahtvorschubsystem 250 mit Lackdraht 251, Führungsrohr 253 mit konusförmiger Spitze 254 und Austrittsöffnung 255. Wie Figur 5 ferner zeigt, ist ein Gehäuse 256 vorhanden, in dessen Innenraum 257 der Lackdraht 251 über eine Umlenkrolle 258 und zwischen antreibbare Antriebsrollen 259a, 259b hindurch in das Führungsrohr 253 hinein geführt wird. Bei angetriebenen Antriebsrollen 259a, 259b wird somit der Lackdraht in Richtung auf die Austrittsöffung 255 hin oder von dieser zurück bewegt. Dieser Teil des Aufbaus des Lackdrahtvorschubsystems 250 stimmt mit einem möglichen Aufbau des Lackdrahtvorschubsytems 150 überein.

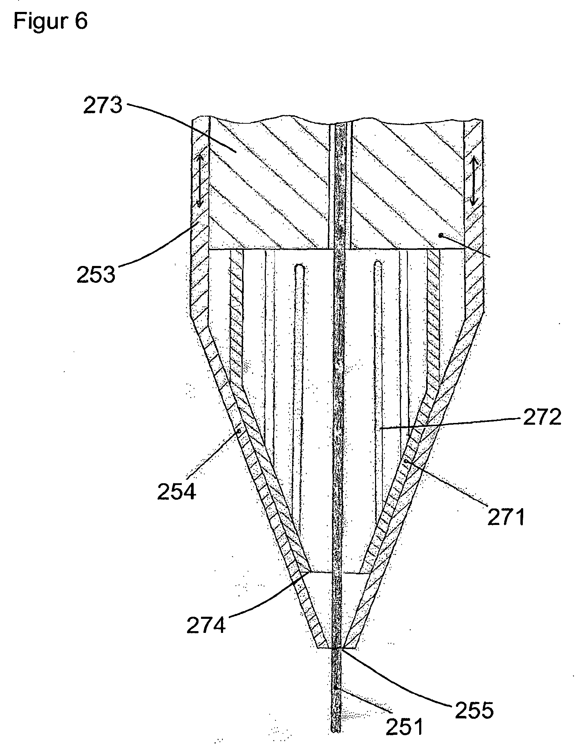

Der wesentliche Unterschied zwischen den Lackdrahtvorschubsystemen 150 und 450 einerseits und 250 andererseits betrifft nur die in Figur 6 dargestellte Weiterbildung, die im Lackdrahtvorschubsystem 150 bzw. 450 zwar ebenfalls realisiert sein könnte, aber für das Lackdrahtvorschubsystem 250 zwingend erforderlich ist, weil sonst das Laserlötsystem 200 keine Schneidvorrichtung aufweisen würde. Wie in Figur 6 durch die im Bereich des Führungsrohrs 253 eingezeichneten Pfeile verdeutlicht ist, sind Führungsrohr 253 und die am Führungsrohr 253 angeordnete konusförmige Spitze 254 relativ zu einem zumindest abschnittsweise innerhalb der konusförmigen Spitze 254 angeordneten geschlitzten Konus 271 mit Schlitzen 272, der auf einer innerhalb des Führungsrohrs 253 angeordneten Lackdrahtführung 273 abgestützt ist, verschiebbar. Diese Relativbewegung kann beispielsweise dadurch realisiert werden, dass das Führungsrohr 253 am Gehäuse 256 in axialer Richtung (angetrieben) verschiebbar gelagert ist, es könnte aber auch eine in dieser Richtung verschiebbare Lackdrahtführung 273 vorgesehen werden.

Diese Anordnung führt dazu, dass durch Relativverschiebung der Abstand des geschlitzten Konus 271 von der Austrittsöffnung 255 verringert wird, so dass die Schlitze 272 zusammengedrückt werden und der Lackdraht 251 an der Spitze 274 des geschlitzten Konus 271 abgetrennt wird.

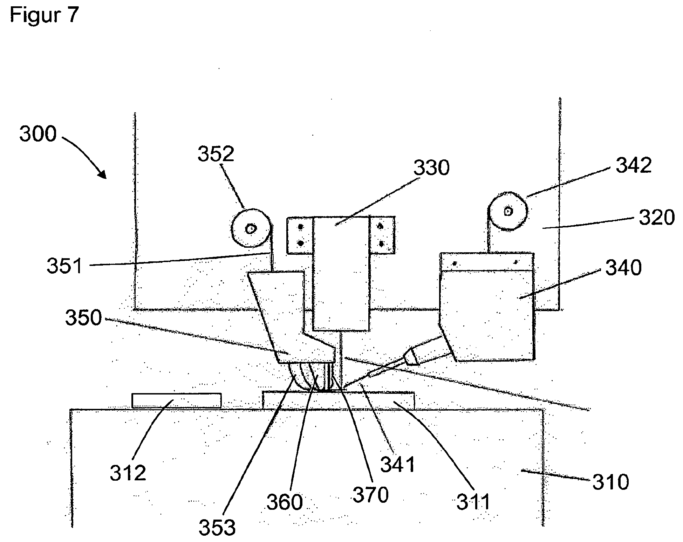

Figur 7 zeigt ein Beispiel eines Laserlötsystems 300 mit Werkstückaufnahme 310 mit elektrischen Baugruppen 311, 312, Werkzeugträger 320, Laserquelle 330 mit Laserstrahl 331, Lotdrahtvorschubsystem 340 mit Lotdraht 341 und Lotdrahthaspel 342, Lackdrahtvorschubsystem 350 mit Lackdraht 351, und Lackdrahthaspel 352, und System zum Führen und Positionieren 360 des Lackdrahts 351 sowie mit einer Schneidvorrichtung 370. Die Unterschiede zwischen dem Laserlötsytem 300 und den Laserlötsystemem 100, 200 bestehen in der konkreten Ausgestaltung von Lackdahtvorschubsystem 350, System zum Führen und Positionieren 360 des Lackdrahts 351 und Schneidvorrichtung 370.

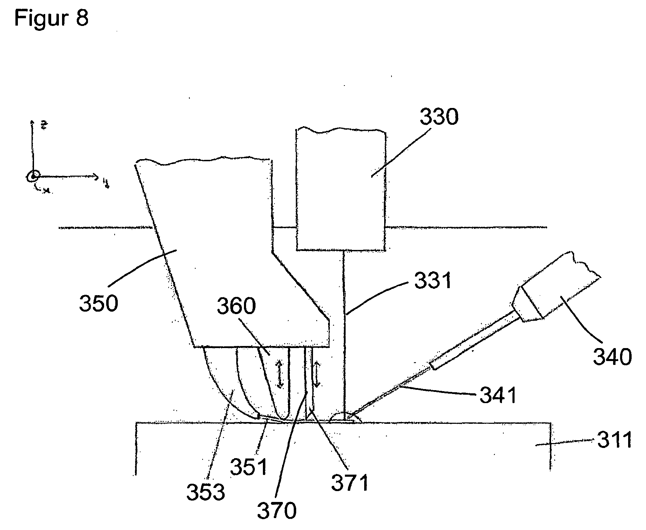

Wie besonders gut anhand der in Figur 8 wiedergegebenen Detaildarstellung des in Figur 7 dargestellten Laserlötsystems 300 zu erkennen ist, ist beim Laserlötsystem 300 das System zum Führen und Positionieren 360 des Lackdrahts 351 als ein - insbesondere durch einen nicht dargestellten Antrieb - in z-Richtung, also senkrecht zur Werkzeugaufnahme 310, verschiebbarer Niederhalter, der am Lackdrahtvorschubsystem 350, welches ein gebogenes Führungsrohr 353 mit Austrittsöffnung 355, dessen Querschnitt sich in Richtung auf die Austrittsöffnung 355 hin verjüngt, aufweist, angeordnet ist, realisiert.

Die Schneidvorrichtung 370 des Laserlötsystems 300 ist mit einer Schneide 371 ausgeführt, die - insbesondere durch einen nicht dargestellten Antrieb - in z-Richtung, also senkrecht zur Werkzeugaufnahme 310 ausgeführt und ebenfalls am Lackdrahtsystem 350 angeordnet ist.

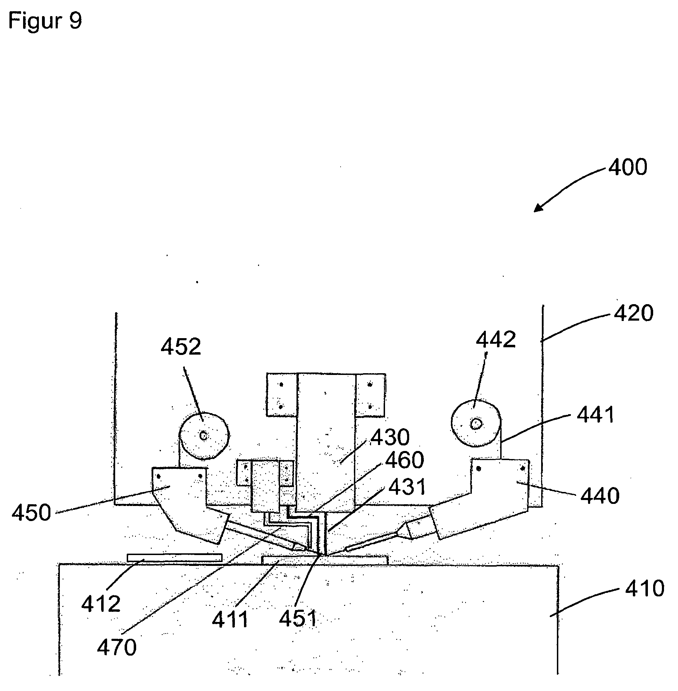

Figur 9 zeigt ein Beispiel eines Laserlötsystems 400 mit Werkstückaufnahme 410 mit elektrischen Baugruppen 411, 412, Werkzeugträger 420, Laserquelle 430 mit Laserstrahl 431, Lotdrahtvorschubsystem 440 mit Lotdraht 441 und Lotdrahthaspel 442, Lackdrahtvorschubsystem 450 mit Lackdraht 451, und Lackdrahthaspel 452, und System zum Führen und Positionieren 460 des Lackdrahts 451 sowie mit einer Schneidvorrichtung 470. Das Laserlötsystem 400 ist weitgehend identisch zum Laserlötsystem 200 gemäß Figur 4 aufgebaut, unterscheidet sich aber dadurch von diesem, dass die Schneidvorrichtung 470 nicht als in das Lackdrahtvorschubsystem 450 integrierte mechanische Schneidvorrichtung 270 ausgeführt ist, sondern als thermische Schneidvorrichtung 470.

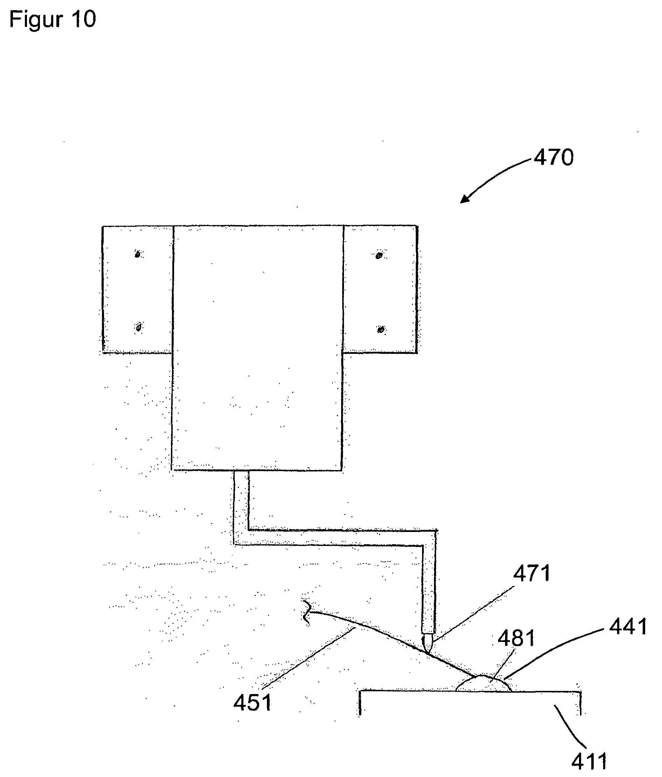

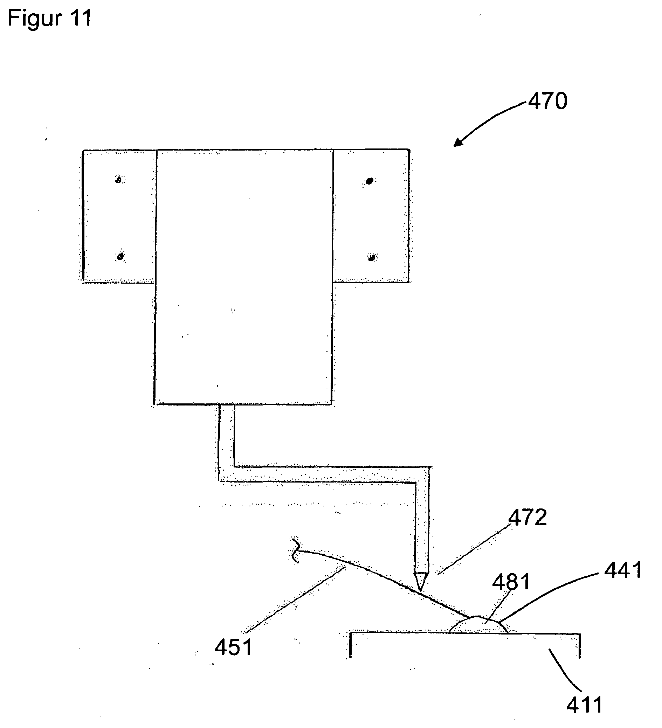

Beispiele für die konkrete Ausgestaltung einer solchen thermischen Schneidvorrichtung 470 sind in den Figuren 10 und 11 dargestellt, bei denen der jeweils gezeigte Lackdraht 451 nach dem Erzeugen einer Lötstelle 481 auf einer elektrischen Baugruppe 411 mit einer Flamme 471 bzw. mit einer, z. B. elektrisch, beheizten Werkzeugspitze 472 durchtrennt wird.

### Bezugszeichenliste

- 1,2,: elektrische Baugruppe
- 3: Lackdraht
- 4,4a,4b,4c,5,5a,5b,5c: Kontaktfeld
- 100,200,300,400: Laserstrahllötsystem
- 110,210,310,410: Werkstückaufnahme
- 111,112,211,212, 311,312,411,412: elektrische Baugruppe
- 120,220,320,420: Werkzeugträger
- 130,230,330,430: Laserquelle
- 131,231,331,431: Laserstrahl
- 140,240,340,440: Lotdrahtvorschubsystem
- 141,241,341,441: Lotdraht
- 142,242,342,442: Lotdrahthaspel
- 150,250,350,450: Lackdrahtvorschubsystem
- 151,251,351,451: Lackdraht
- 152,252,352,452: Lackdrahthaspel
- 153,253,353,453: Führungsrohr
- 154,254,454: konusförmige Spitze
- 155,255,355,455: Austrittsöffnung
- 160,260,360,460: System zum Führen und Positionieren
- 161: erste Platte
- 162: zweite Platte
- 163,164: Bohrung
- 165: Führung
- 170,270,370,470: Schneidvorrichtung
- 256: Gehäuse
- 257: Innenraum
- 258: Umlenkrolle
- 259a,259b: Antriebsrollen

- 271: geschlitzter Konus
- 272: Schlitze
- 273: Lackdrahtführung
- 274: Spitze
- 371: Schneide
- 471: Flamme
- 472: beheizte Werkzeugspitze
- 481: Lötstelle

## Patentansprüche

1. Laserstrahllötsystem (100) mit einer Werkstückaufnahme (110), mit einer Laserstrahlquelle (130) und mit einem Lotdrahtvorschubsystem (140), wobei die Laserstrahlquelle (130) und das Lotdrahtvorschubsystem (140) relativ zu der Werkstückaufnahme (110) in einer Ebene parallel zu der Werkstückaufnahme (110) und senkrecht zur Werkstückaufnahme (110) verschiebbar angeordnet sind und um eine senkrecht zur Werkstückaufnahme (110) stehende Achse rotierbar angeordnet sind,
wobei das Laserstrahllötsystem (100) ferner ein Lackdrahtvorschubsystem (150), ein System zum Führen und Positionieren (160) eines Lackdrahts (151) und eine Schneidvorrichtung (170) zum Durchtrennen des Lackdrahts (151) aufweist, **dadurch gekennzeichnet, dass** diese ebenfalls relativ zu der Werkstückaufnahme (110) in einer Ebene parallel zu der Werkstückaufnahme (110) und senkrecht zur Werkstückaufnahme (110) verschiebbar angeordnet sind und um eine senkrecht zur Werkstückaufnahme (110) stehende Achse rotierbar angeordnet sind, wobei die Schneidvorrichtung (170) zum Durchtrennen des Lackdrahts (151) in das System zum Führen und Positionieren (160) des Lackdrahts (151) integriert ist und das System zum Führen und Positionieren (160) des Lackdrahts (151) mindestens eine erste Platte (161) und eine zweite Platte (162), die mittels mindestens eines Antriebs unabhängig voneinander verschiebbar sind und jeweils mindestens eine Bohrung (163,164) aufweisen, die so angeordnet ist, dass in mindestens einer relativen Position der ersten Platte (161) und der zweiten Platte (162) zueinander die Bohrung (163) der ersten Platte (161) und die Bohrung (164) der
zweiten Platte (162) zumindest partiell überlappen und dass in mindestens einer relativen Position der ersten Platte (161) und der zweiten Platte (162) zueinander die Bohrung (163) der ersten Platte (161) und die Bohrung (164) der zweiten Platte (162) nicht überlappen.

2. Laserstrahllötsystem (200) nach Anspruch 1,
**dadurch gekennzeichnet, dass** das System zum Führen und Positionieren (260, 360, 460) des Lackdrahts (251, 252, 253) einen Niederhalter aufweist.

## Claims

1. A laser beam soldering system (100) having a tool mount (110), having a laser beam source (130) and having a soldering wire feeder system (140), wherein the laser beam source (130) and the soldering wire feeder system (140) are arranged displaceable relative to the workpiece mount (110) in a plane in parallel with the workpiece mount (110) and perpendicular to the workpiece mount (110) and are arranged rotatable about an axis standing perpendicular to the workpiece mount (110),
wherein the laser beam soldering system (100) furthermore has a coated wire feeder system (150), a system for guiding and positioning (160) a coated wire (151) and a cutting apparatus (170) for severing the coated wire (151), **characterised in that** they are likewise arranged displaceable relative to the workpiece mount (110) in a plane in parallel with the workpiece mount (110) and perpendicular to the workpiece mount (110) and are arranged rotatable about an axis standing perpendicular to the workpiece mount (110), with the cutting apparatus (170) for severing the coated wire (151) being integrated into the system for guiding and positioning (160) the coated wire (151) and the system for guiding and positioning (160) the coated wire (151) having at least one first plate (161) and one second plate (162) which are displaceable independently of one another by means of at least one drive and which each have at least one bore (163, 164), said bore being arranged such that the bore (163) of the first plate (161) and the bore (164) of the second plate (162) at least partially overlap in at least one relative position of the first plate (161) and of the second plate (162) towards one another and such that the bore (163) of the first plate (161) and the bore (164) of the second plate (162) do not overlap in at least one relative position of the first plate (161) and of the second plate (162) towards one another.

2. A laser beam soldering system (200) in accordance with claim 1, **characterised in that** the system for guiding and positioning (260, 360, 460) the coated wire (251, 252, 253) has a holding-down device.

## Revendications

1. Système de brasage par faisceau laser (100) comprenant un logement pour pièces à oeuvrer (110), comprenant une source de faisceau laser (130) et comprenant un système d'amenée de fil de brasage (140), dans lequel la source de faisceau laser (130) et le système d'amenée de fil de brasage (140) sont agencés avec possibilité de translation dans un plan parallèle au logement pour pièces à oeuvrer (110) et perpendiculairement au logement pour pièces à oeuvrer (110) et avec possibilité de rotation autour d'un axe dressé perpendiculairement par rapport au logement pour pièces à oeuvrer (110),
dans lequel le système de brasage par faisceau laser (100) comprend en outre un système d'amenée de fil de peinture (150), un système pour guider et positionner (160) un fil de peinture (151), et un dispositif de coupe (170) pour couper le fil de peinture (151),
**caractérisé en ce que** ceux-ci sont, par rapport au logement pour pièces à oeuvrer (110), également agencés avec possibilité de translation dans un plan parallèle au logement pour pièces à oeuvrer (110) et perpendiculairement au logement pour pièces à oeuvrer (110) et avec possibilité de rotation autour d'un axe dressé perpendiculairement par rapport au logement pour pièces à oeuvrer (110),
dans lequel le dispositif de coupe (170) pour couper le fil de peinture (151) est intégré dans le système pour guider et positionner (160) le fil de peinture (151), et le système pour guider et positionner (160) le fil de peinture (151) comprend au moins une première plaque (161) et une seconde plaque (162) qui sont déplaçables indépendamment l'une de l'autre au moyen d'au moins un entraînement et comprennent respectivement au moins un perçage (163, 164) qui est agencé de telle façon que dans au moins une position relative de la première plaque (161) et de la seconde plaque (162) l'une par rapport à l'autre, le perçage (163) de la première plaque (161) et le perçage (164) de la seconde plaque (162) se chevauchent au moins partiellement, et **en ce que** dans au moins une position relative de la première plaque (161) et de la seconde plaque (162) l'une par rapport à l'autre, le perçage (163) de la première plaque (161) et le perçage (164) de la seconde plaque (162) ne se chevauchent pas.

2. Système de brasage par faisceau laser (200) selon la revendication 1, **caractérisé en ce que** le système pour guider et positionner (260, 360, 460) le fil de peinture (251, 252, 253) comprend un dispositif de maintien vers le bas.
